# EUROPÄISCHE PATENTSCHRIFT

(11) **EP 0 965 849 B1**
(45) Veröffentlichungstag und Bekanntmachung des Hinweises auf die Patenterteilung: **29.12.2004**
(21) Anmeldenummer: 99108404.7
(22) Anmeldetag: 29.04.1999
(51) Int. Cl.: G01R 15/14, F02P 17/12, G01R 1/22

(54) **Triggerzange zum Erfassen von Hochspannungsimpulsen**
Trigger clip-on to detect high voltage pulses
Pince de déclenchement pour la détection d'impulsions haute tension

(30) Priorität: 19.05.1998 DE 19822315
(43) Veröffentlichungstag der Anmeldung: 22.12.1999
(73) Patentinhaber: ROBERT BOSCH GMBH, 70442 Stuttgart (DE)
(72) Erfinder: Dittmann, Karl-Heinz, 73054 Eislingen (DE); Fischer, Uwe, 71409 Schwaikheim (DE); Lehmann, Siegfried, 73061 Ebersbach (DE)

(56) Entgegenhaltungen:
- DE-A- 2 606 868
- DE-C- 4 125 856
- US-A- 3 621 392
- US-A- 5 473 244
- PATENT ABSTRACTS OF JAPAN vol. 004, no. 184 (P-041), 18. Dezember 1980 (1980-12-18) & JP 55 128157 A (TOHOKU ELECTRIC POWER CO INC), 3. Oktober 1980 (1980-10-03)

## Beschreibung

### Stand der Technik

Die Erfindung betrifft eine Triggerzange zum Erfassen von Hochspannungsimpulsen mit zwei an ein Hochspannungskabel anklemmbaren Klemmteilen und mit einem induktiven Sensor, der aus zwei Teilen in Form von Schalen eines Ferritkerns besteht, von denen mindestens einer eine Wicklung einer Spule trägt und die in zwei abgeschirmten Haltern der Klemmteile untergebracht sind.

Eine Triggerzange dieser Art ist in der DE 26 06 868 A1 angegeben. Derartige Triggerzangen werden mit Vorteil zur Drehzahlerfassung in Kraftfahrzeugen und Motorrädern eingesetzt, wobei die Zündimpulse auf dem Zündkabel gemessen werden, wie die DE 34 00 787 A1 zeigt. Mit einer Triggerzange mit induktivem Sensor kann zudem sowohl auf der Primärseite als auch der Sekundärseite der Zündspule auf den Zündstrom getriggert werden.

Wie die DE 44 12 642 A1 zeigt, ist auch eine Triggerzange mit einem kapazitiven Sensor bekannt. Dabei bildet die Zündleitung und ein elektrisch leitfähiges Element mit der Abschirmung (Masseleitung) einen kapazitiven Spannungsteiler.

Der Leiter der Zündleitung bildet mit dem elektrisch leitfähigen Element einen Kondensator mit berechenbarer oder experimentell bestimmbarer Kapazität. Eine Triggerzange mit kapazitivem Sensor ist sinnvoll nur auf der Sekundärseite von Zündanlagen einsetzbar.

Bei der Messung auf der Sekundärseite einer Zündanlage eines Kraftfahrzeugs wird mit einem induktiven Sensor der Triggerzeitpunkt erfasst, der zeitliche Verlauf der Zündspannung auf der Zündleitung kann jedoch nicht beobachtet werden.

Die Triggerzange mit einem kapazitiven Sensor erfasst wohl den Spannungsverlauf auf dem Zündkabel. In vielen Fällen erlaubt eine Triggerzange diese Art wegen der hohen Empfindlichkeit gegen Übersprechen keinen zuverlässigen Trigger.

In der US 5,473,244 A ist eine Aufklemmzange für ein stromdurchflossenes elektrisches Kabel oder eine Kabelanordnung angegeben. Die Aufklemmzange umfasst sowohl einen Strom- als auch einen Spannungssensor, wobei ein kapazitiver Sensor eine Spannung und Spulensensoren Magnetfelder erfassen, die mit dem Strom im Kabel zusammenhängen.

Es ist Aufgabe der Erfindung, eine Triggerzange der eingangs erwähnten Art zu schaffen, die auf einfache Art sowohl zur Erfassung der Triggerzeitpunkte als auch des Spannungsverlaufs auf einem Hochspannungskabel verwendet werden kann.

Diese Aufgabe wird nach der Erfindung dadurch gelöst, dass zumindest in einem der beiden Klemmteile ein elektrisch leitfähiges Element untergebracht ist, das mit dem Leiter des Hochspannungskabels einen kapazitiven Sensor bildet, und dass das Element des kapazitiven Sensors als Folie ausgebildet ist, die zusammen mit einer Schale des Ferritkerns von diesem mittels einer nichtleitenden Schicht isoliert in dem zugeordneten Klemmteil festgelegt ist. Es wird stets nur ein und dieselbe Triggerzange verwendet, die durch den zusätzlichen Einbau eines kapazitiven Sensors nicht nennenswert verteuert ist. Die Handhabung ist vereinfacht, da diese Triggerzange sowohl auf der Primärseite als auch Sekundärseite einer Zündanlage eines Kraftfahrzeuges sowohl zum Erfassen der Triggerzeitpunkte als auch zur Beobachtung des Spannungsverlaufs der Zündimpulse verwendet werden kann.

Für den kapazitiven Sensor ist vorgesehen, dass das Element des kapazitiven Sensors als Folie ausgebildet ist, die zusammen mit einer Schale des Ferritkerns in dem zugeordneten Klemmteil festgelegt ist.

Die Triggerzange kann nach einer Ausgestaltung so ausgebildet sein, dass die beiden Anschlüsse der Spule des induktiven Sensors mit einer zweiadrigen Anschlußleitung und das Element des kapazitiven Sensors mit einer Ader der zweiadrigen Anschlußleitung verbunden sind. Zudem kann vorgesehen sein, dass eine Ader der zweiadrigen Anschlußleitung als Masseleitung verwendet ist. In beiden Fällen lässt sich eine Ader der Anschlussleitung einsparen. Damit bei der Messung die Schalen des Ferritkerns unter Vorspannung geschlossen anliegen, sieht eine Weiterbildung vor, dass die Halter senkrecht zum Hochspannungskabel abgefedert in den beiden, drehbar miteinander verbundenen Klemmteilen gehalten sind. Dabei kann die Abschirmung der Sensoren dadurch erreicht werden, dass die Halter aus metallisiertem Kunststoff oder metallbeschichtetem Kunststoff bestehen und als Abschirmung mit der Masseleitung verbunden sind.

Ist zudem vorgesehen, dass die beiden Klemmteile mittels eines Federelementes in der Schließstellung gehalten sind, dann wird bei am Hochspannungskabel angelegter Triggerzange über die beiden Klemmteile ein ausreichender Halt geschaffen.

Die Erfindung wird anhand eines in der Zeichnung dargestellten Ausführungsbeispiels näher erläutert. Es zeigen:
- Fig. 1: im Längsschnitt eine Triggerzange mit einem induktivem und einem kapazitivem Sensor und
- Fig. 2: das elektrische Ersatzschaltbild der Triggerzange nach Fig. 1.

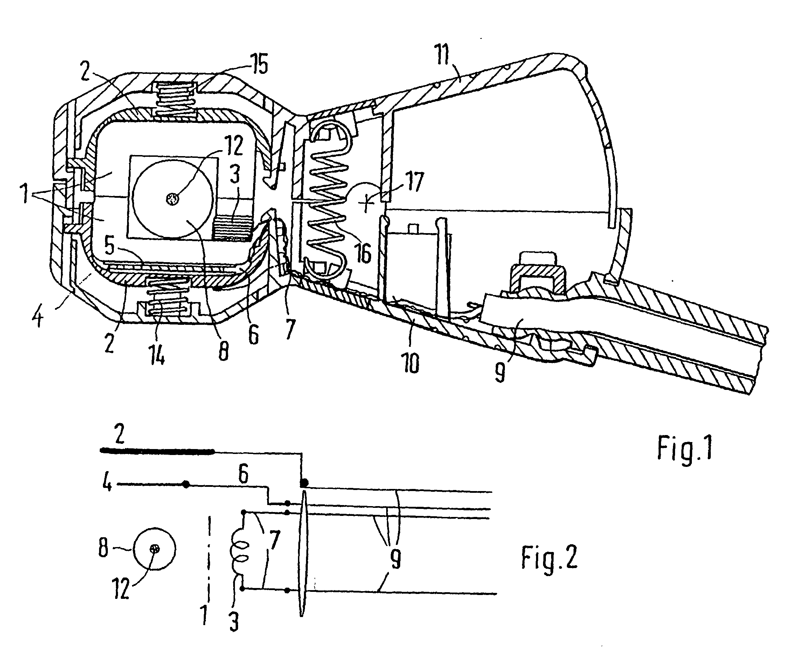

Wie Fig. 1 zeigt, ist an einer Anschlußleitung 9 ein Klemmteil 10 einer Triggerzange festgelegt. Mit diesem Klemmteil 10 ist ein zweites Klemmteil 11 drehbar verbunden, wie die angedeutete Drehachse 17 erkennen läßt. Der Anschlußleitung 9 abgekehrt hält ein Federelement 16 die beiden Klemmteile 10 und 11 in der Ausgangsstellung. In die beiden Klemmteile 10 und 11, die einander zugekehrt Aufnahmen für die Sensoren bilden, werden zwei Teile in Form von Schalen eines Ferritkerns 1 eingesetzt. Eine der beiden Schalen des Ferritkerns 1 trägt in bekannter Weise eine Wicklung, die eine Spule 3 bildet. Diese Spule 3 ist über Anschlüsse 7 mit der Anschlußleitung 9 verbunden, wie Fig. 2 zeigt. Die Schalen des Ferritkerns 1 sind in Haltern 2 gehalten, die aus metallisiertem Kunststoff oder einem metallbeschichtetem Kunststoff hergestellt sind und als Abschirmung dienen. Dabei sind die Halter 2 mittels Federn 14 und 15 senkrecht zum Hochspannungskabel 8 in den Klemmteilen 10 und 11 gehalten. Die Schalen des Ferritkerns 1 können sich daher in der Anlagestellung der Triggerzange optimal und über Vorspannung geschlossen um das am Hochspannungskabel 8 anlegen. Mit der zugeordneten Schale des Ferritkerns 1 ist in dem Klemmteil 10 gleichzeitig auch ein in Form einer Folie ausgebildetes, elektrisch leitfähiges Element 4 in dem Halter 2 festgelegt. Vorteilhafterweise wird das elektrisch leitfähige Element 4 mit einer elektrisch nichtleitenden Schicht 5 vom Ferritkern 1 isoliert.

Dieses Element 4 bildet mit dem Leiter 12 des Hochspannungskabels 8 einen Kondensator des kapazitiven Sensors. Das Element 4 ist über einen Anschluß 6 mit der Anschlußleitung 9 verbunden. Wie Fig. 2 zeigt, kann die Abschirmung (in Form der Halter 2) ebenfalls mit der Anschlußleitung 9 verbunden sein. Dabei könnte die Abschirmung 2 und/oder eine Ader des induktiven Sensors auch als Masseleitung verwendet und die Adernzahl der Anschlußleitung 9 entsprechend verringert werden.

## Patentansprüche

1. Triggerzange zum Erfassen von Hochspannungsimpulsen mit zwei an ein Hochspannungskabel (8) anklemmbaren Klemmteilen (10, 11) und mit einem induktiven Sensor, der aus zwei Teilen in Form von Schalen eines Ferritkerns (1) besteht, von denen mindestens einer eine Wicklung einer Spule (3) trägt und die in zwei abgeschirmten Haltern (2) der Klemmteile (10, 11) untergebracht sind,
**dadurch gekennzeichnet,**
**dass** zumindest in einem der beiden Klemmteile (10, 11) ein elektrisch leitfähiges Element (4) untergebracht ist, das mit dem Leiter (12) des Hochspannungskabels (8) einen kapazitiven Sensor bilden kann, und
**dass** das Element (4) des kapazitiven Sensors als Folie ausgebildet ist, die zusammen mit einer Schale des Ferritkerns (1) von diesem mittels einer nichtleitenden Schicht (5) isoliert in dem zugeordneten Klemmteil (10 oder 11) festgelegt ist.

2. Triggerzange nach Anspruch 1,
**dadurch gekennzeichnet,**
**dass** die beiden Anschlüsse der Spule (3) des induktiven Sensors mit einer zweiadrigen Anschlußleitung (9) und das Element (4) des kapazitiven Sensors mit einer Ader der zweiadrigen Anschlußleitung (9) verbunden sind.

3. Triggerzange nach Anspruch 1 oder 2,
**dadurch gekennzeichnet,**
**dass** eine Ader der zweiadrigen Anschlußleitung (9) als Masseleitung verwendet ist.

4. Triggerzange nach einem der Ansprüche 1 bis 3,
**dadurch gekennzeichnet,**
**dass** die Halter (2) senkrecht zum Hochspannungskabel (8) abgefedert in den beiden drehbar miteinander verbundenen Klemmteilen (10, 11) gehalten sind.

5. Triggerzange nach Anspruch 4,
**dadurch gekennzeichnet,**
**dass** die Halter (2) aus metallisiertem Kunststoff oder metallbeschichtetem Kunststoff bestehen und als Abschirmung mit der Masseleitung verbunden sind.

6. Triggerzange nach einem der Ansprüche 1 bis 5,
**dadurch gekennzeichnet,**
**dass** die beiden Klemmteile (10, 11) mittels eines Federelementes (16) in der Schließstellung gehalten sind.

## Claims

1. Clip-on trigger sensor for detecting high-voltage pulses, having two clamping parts (10, 11) which can be clamped onto a high-voltage cable (8) and having an inductive sensor which comprises two parts in the form of shells of a ferrite core (1), at least one of these parts bearing a winding of a coil (3) and these parts being accommodated in two screened holders (2) of the clamping parts (10, 11),
**characterized**
**in that** an electrically conductive element (4) is accommodated at least in one of the two clamping parts (10, 11) and can form a capacitive sensor with the conductor (12) of the high-voltage cable (8), and
**in that** the element (4) of the capacitive sensor is in the form of a foil which is fixed in the associated clamping part (10 or 11) together with a shell of the ferrite core (1) and insulated from the latter by means of a non-conducting layer (5).

2. Clip-on trigger sensor according to Claim 1,
**characterized**
**in that** the two terminals of the coil (3) of the inductive sensor are connected to a twin-core connecting line (9), and the element (4) of the capacitive sensor is connected to one core of the twin-core connecting line (9).

3. Clip-on trigger sensor according to Claim 1 or 2,
**characterized**
**in that** one core of the twin-core connecting line (9) is used as earth line.

4. Clip-on trigger sensor according to one of Claims 1 to 3,
**characterized**
**in that** the holders (2) are held perpendicular to the high-voltage cable (8) such that they are sprung in the two clamping parts (10, 11) connected rotatably to one another.

5. Clip-on trigger sensor according to Claim 4,
**characterized**
**in that** the holders (2) are made of metallized plastic or metal-coated plastic and are connected to the earth line as a screen.

6. Clip-on trigger sensor according to one of Claims 1 to 5,
**characterized**
**in that** the two clamping parts (10, 11) are held in the closed position by means of a spring element (16).

## Revendications

1. Pince de déclenchement pour la détection d'impulsions à haute tension dotée de deux pièces de serrage (10, 11) pouvant être serrées contre un câble haute tension (8) et d'un capteur inductif composé de deux pièces en forme de coquilles d'un tore de ferrite (1) dont au moins une porte un bobinage d'une bobine (3) et qui sont disposées dans deux appuis (2) protégés des pièces de serrage (10, 11),
**caractérisée en ce qu'**
un élément (4) électriquement conducteur est disposé dans au moins l'une des deux pièces de serrage (10, 11), lequel élément peut former un capteur capacitif avec le conducteur (12) du câble haute tension (8) et l'élément (4) du capteur capacitif est conçu en tant que feuille fixée dans la pièce de serrage associée (10 ou 11) conjointement avec une coquille du tore de ferrite (1) de manière à être isolée de celui-ci à l'aide d'une couche non conductrice (5).

2. Pince de déclenchement selon la revendication 1,
**caractérisée en ce que**
les deux raccordements de la bobine (3) du capteur inductif sont reliés à une conduite de raccordement (9) à deux brins et l'élément (4) du capteur capacitif est relié à un brin de la conduite de raccordement (9) à deux brins.

3. Pince de déclenchement selon la revendication 1 ou 2,
**caractérisée en ce qu'**
un brin de la conduite de raccordement (9) à deux brins est utilisé en tant que conduite de mise à la masse.

4. Pince de déclenchement selon l'une quelconque des revendications 1 à 3,
**caractérisée en ce que**
les appuis (2) sont maintenus à la verticale du câble haute tension (8) de manière élastique dans les deux pièces de serrage (10, 11) reliées l'une à l'autre de manière à pouvoir pivoter.

5. Pince de déclenchement selon la revendication 4,
**caractérisée en ce que**
les appuis (2) sont en matière plastique métallisée ou en matière plastique recouverte de métal et sont reliés en tant qu'écran à la conduite de mise à la masse.

6. Pince de déclenchement selon l'une quelconque des revendications 1 à 5,
**caractérisée en ce que**
les deux pièces de serrage (10, 11) sont maintenues en position fermée à l'aide d'un élément à ressort (16).
